# EUROPÄISCHE PATENTSCHRIFT

(11) **EP 0 871 207 B1**
(45) Veröffentlichungstag und Bekanntmachung des Hinweises auf die Patenterteilung: **05.09.2001**
(21) Anmeldenummer: 98890055.1
(22) Anmeldetag: 03.03.1998
(51) Int. Cl.: H01L 21/00

(54) **Verfahren und Vorrichtung zum einseitigen Bearbeiten scheibenförmiger Gegenstände**
Method and apparatus for single-side processing of disk-shaped articles
Procédé et appareil pour traiter d'un seul côté des objets en forme de disque

(30) Priorität: 26.03.1997 AT 52797
(43) Veröffentlichungstag der Anmeldung: 14.10.1998
(73) Patentinhaber: SEZ Semiconductor-Equipment Zubehör für die Halbleiterfertigung AG, 9500 Villach (AT)
(72) Erfinder: Guggenberger, Günther, 9800 Spittal an der Drau (AT)
(74) Vertreter: Beer, Manfred, Dipl.-Ing.

(56) Entgegenhaltungen:
- EP-A- 0 467 624
- EP-A- 0 701 276
- WO-A-95/23428
- DE-A- 3 522 465
- US-A- 5 513 668

## Beschreibung

Die Erfindung betrifft ein Verfahren und eine Vorrichtung zum einseitigen Behandeln scheibenförmiger Gegenstände, beispielsweise zum Trockenätzen von Siliziumwafers, von welchen eine beidseitig vorhandene Schicht, z.B. eine Oxidschicht nur auf einer Seite entfernt werden soll.

Die Erfindung betrifft weiters eine Vorrichtung, mit der das Verfahren der Erfindung ausgeführt werden kann.

Bekannt sind Naßätzgeräte, mit welchen scheibenförmige Gegenstände, insbesondere Siliziumwafer mit einem flüssigen Ätzmedium behandelt werden, um durch Ätzen eine auf dem scheibenförmigen Gegenstand vorhandene Schicht, z.B. eine Oxidschicht auf einem Siliziumwafer zu entfernen.

Bekannt sind auch Verfahren und Vorrichtungen zum Ätzen von Halbleiterscheiben mit einem gasförmigen Ätzmedium (Trockenätzen). Beispielsweise wird eine Oxidschicht von Siliziumwafern durch Behandeln des Wafer mit in Stickstoff gelöstem Fluorwasserstoff (HF-Dämpfe) entfernt.

Aus der DE 35 22 465 A ist es bekannt, einen Siliziumwafer, der mit einem flüssigen Ätzmedium behandelt wird, auf seiner Unterseite durch Bespülen mit deionisiertem Wasser vor einem ätzenden Angriff zu schützen. In der DE 35 22 465 A ist zwar auch ein Ringspalt erwähnt, jedoch ist dieser Ringspalt durch die geometrischen Abmessungen eines tellerförmigen Elementes und dem waferseitigen Ende eines Tragekörpers bestimmt. Bei der bekannten Vorrichtung wird der Wafer durch gesondert angelegten Unterdruck am Tragekörper festgehalten.

Aus der gattungsbildenden EP 0 467 624 A ist ein Verfahren zum Behandeln von Wafern bekannt, das die folgenden Verfahrensschritte aufweist:
a) die zu behandelnde Seite des scheibenförmigen Gegenstandes bzw. die nicht zu behandelnde Seite des scheibenförmigen Gegenstandes werden mit einem Behandlungs-Medium bzw. mit einem inerten Medium umspült;
b) ein gasförmiges Behandlungs-Medium bzw. ein inertes, gasförmiges Medium werden auf die zu behandelnde Seite bzw. auf die nicht zu behandelnde Seite des scheibenförmigen Gegenstandes geblasen;
c) das inerte, gasförmige Medium wird bis in den Bereich des Umfangrandes des scheibenförmigen Gegenstandes geführt;
d) das inerte, gasförmige Medium tritt im Bereich des Umfangrandes des scheibenförmigen Gegenstandes durch einen Ringspalt aus dem mit dem inerten, gasförmigen Medium beaufschlagten Raum, aus; und
e) der Ringspalt wird auf einer Seite vom Außenrand des vom scheibenförmigen Gegenstand und auf der anderen Seite der Seitenwand des mit dem inerten, gasförmigen Medium beaufschlagten Raumes begrenzt.

Aufgabe der Erfindung ist es, ein Verfahren und eine Vorrichtung zum Durchführen derselben anzugeben, mit welchen sichergestellt ist, daß das auf die eine Seite des scheibenförmigen Gegenstandes einwirkende Behandlungs-Medium auf die andere, nicht zu behandelnde Seite des Gegenstandes nicht oder nicht unkontrolliert einwirken kann.

Erfindungsgemäß wird diese Aufgabe mit einem Verfahren, das die Merkmale des Anspruches 1 aufweist, gelöst.

Die Erfindung betrifft weiters eine zum Durchführen des erfindungsgemäßen Verfahrens bevorzugt verwendbare Vorrichtung, welche die Merkmale des Vorrichtungshauptanspruches aufweist.

Bevorzugte und vorteilhafte Ausgestaltungen des erfindungsgemäßen Verfahrens und der erfindungsgemäßen Vorrichtung sind Gegenstand der Unteransprüche.

Dadurch, daß bei dem erfindungsgemäßen Verfahren die nicht zu behandelnde Fläche des scheibenförmigen Gegenstandes, z.B. des Siliziumwafers, mit einem inerten gasförmigen Medium beblasen wird, wird zuverlässig verhindert, daß das gasförmige Behandlungs-Medium unkontrolliert, z.B. über einen Randbereich hinaus die nicht zu behandelnden Fläche des scheibenförmigen Gegenstandes angreift.

Weitere Einzelheiten und Merkmale des erfindungsgemäßen Verfahrens und der erfindungsgemäßen Vorrichtung ergeben sich aus der nachstehenden Beschreibung, in welcher auf die angeschlossene Zeichnung Bezug genommen wird.

Es zeigt:
Fig. 1 im Axialschnitt schematisch eine zum Durchführen des erfindungsgemäßen Verfahrens geeignete Vorrichtung,
Fig. 2 die Platte, an welcher der scheibenförmige Gegenstand gehalten ist, in Draufsicht und
Fig. 3 und 4 eine andere Ausführungsform.

Wenngleich in der folgenden Beschreibung auf das Ätzen zum Entfenern einer Oxid-Schicht auf einem Silizium-Wafer Bezug nimmt, ist die Erfindung nicht auf dieses Anwendungsbeispiel beschränkt. Diese Anwendung ist aber bevorzugt.

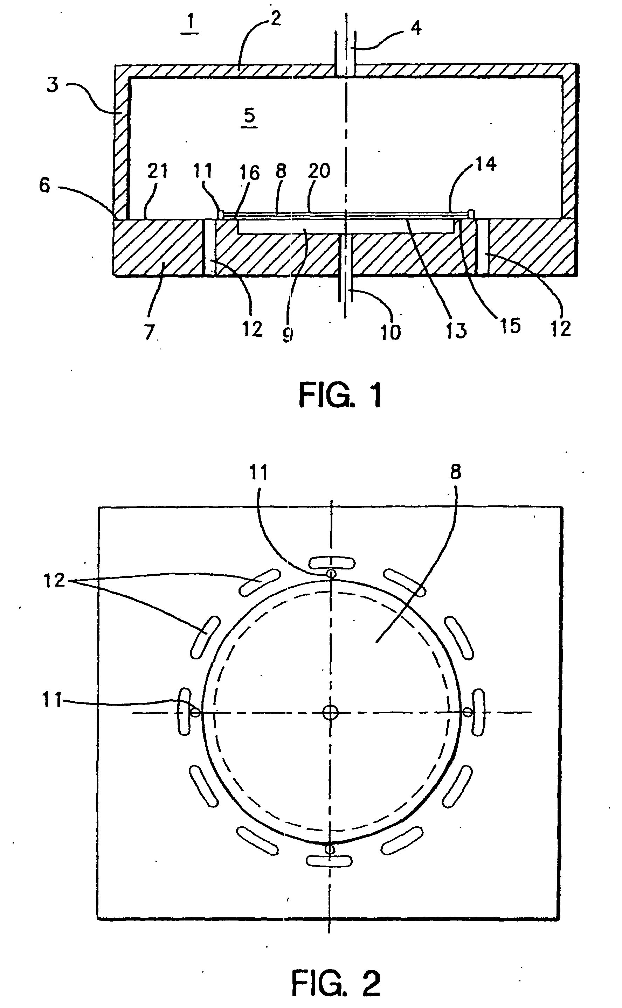

Die in Fig. 1 gezeigte Vorrichtung besteht aus einem unten offenen Gehäuse 1 mit einer Deckelwand 2 und einer Seitenwand 3, das beispielsweise glockenförmig ausgebildet ist. Das Gehäuse 1 besitzt oben einen Anschluß 4 für das Zuführen des gasförmigen Behandlungs-Mediums, z.B. eines Trockenätzmediums (z.B. in Stickstoff gelöster Fluorwasserstoff in die vom Gehäuse 1 umschlossene Prozeßkammer 5. An den freien Rand 6 der Seitenwand 3 des haubenförmigen Gehäuses 1 ist lösbar eine Halteplatte 7 für den zu behandelnden Gegenstand 8, beispielsweise einen Siliziumwafer, angeschlossen.

Die Halteplatte 7 besitzt eine Vertiefung 9, in der eine Leitung 10 für das Zuführen eines gasförmigen Mediums mündet, das bezüglich der zu entfernenden Schicht, z.B. der zu entfernenden Oxidschicht auf einem Siliziumwafer, keine ätzende Wirkung hat, also diesbezüglich inert ist. Beispielsweise kann dieses Gas Stickstoff sein.

In einer (nicht dargestellten) Ausführungsform der erfindungsgemäßen Vorrichtung, die dazu geeignet ist, mehrere scheibenförmige Gegenstände 8 gleichzeitig zu behandeln, sind in der Metallplatte 7 mehrere Vertiefungen 9 der hier beschriebenen Art vorgesehen. Jeder Vertiefung 9 ist eine Leitung 10 zugeordnet, durch die den Vertiefungen 9 inertes, gasförmiges Medium zugeführt werden kann.

Rings um die Vertiefung 9 sind in der Halteplatte 7 nach oben abstehend mehrere, vorzugsweise vier, Stifte 11 vorgesehen, die den Bereich der Halteplatte 7 umgrenzen, in dem der zu behandelnde, scheibenförmige Gegenstand 8 auf die Halteplatte 7 aufgelegt wird. Außerhalb des vertieften Bereiches 9 und außerhalb der Stifte 11 sind rings bei der in Fig. 1 und 2 gezeigten Ausführungsform um die Vertiefung 9 herum mehrere Absaugöffnungen 12 zum Abziehen des gasförmigen Ätzmediums und des durch die Leitung 10 zugeführten inerten, gasförmigen Mediums vorgesehen. Die Öffnungen 12 können wie in Fig. 2 gezeigt, beispielsweise die Umrißform von kreisbogenförmigen Schlitzen haben. Die in den Fig. 1 und 2 gezeigte Ausführungsform wird bevorzugt verwendet, wenn auf die der Halteplatte 7 zugewendete Seite 13 des scheibenförmigen Gegenstandes 8 zur Gänze vor der Wirkung das Behandlungsmedium geschützt sein soll.

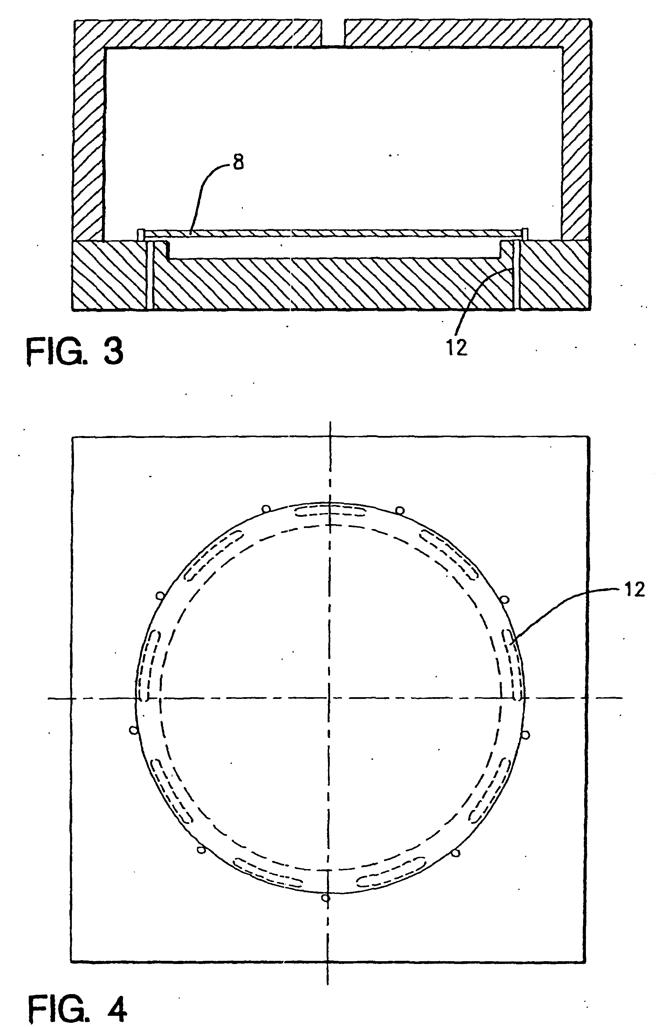

Die in Fig. 3 und 4 gezeigte Ausführungsform der erfindungsgemäßen Vorrichtung wird insbesondere verwendet, wenn der Randbereich der der Halteplatte 7 zugewendeten Seite des scheibenförmigen Gegenstandes 8 kontrolliert der Wirkung das Behandlungsmedium ausgesetzt sein soll. Beispielsweise kann bei Verwendung der in Fig. 3 und 4 gezeigten Ausführungsform im Randbereich der Unterseite 13 definiert eine Oxid-Schicht von einem Silizium-Wafer durch Ätzen entfernt werden. Die in Fig. 3 und 4 gezeigte Ausführungsform unterscheidet sich von der Ausführungsform der Fig. 1 und 2 dadurch, daß die Absaugöffnungen 12 in dem vom Rand des scheibenförmigen Gegenstandes 8 überdeckten Bereich der Halteplatte 7 angeordnet sind.

Bei Betrieb der Vorrichtung wird der zu behandelnde Gegenstand 8, beispielsweise ein Siliziumwafer mit der Fläche 13, die mit dem Behandlungsmedium beispielsweise (N₂ + HF) überhaupt nicht (insbesondere, wenn die Ausführungsform der Fig. 1 und 2 verwendet wird) oder nur in einem definierten Randbereich in Berührung kommen soll, die also nicht oder nicht unkontrolliert geätzt werden soll, nach weisend unten auf die Halteplatte 7 im Bereich der in ihr vorgesehenen Vertiefung 9 innerhalb der nach oben abstehenden Stifte 11 gelegt.

Wenn durch die Leitung 10 in der Halteplatte 7 das inerte, gasförmige Medium, z.B. Stickstoff, in die Vertiefung 9 eingeblasen wird, wird durch das strömende gasförmige Medium der Rand 14 des Gegenstandes 8 vom Rand 15 der Vertiefung 9, also von der Oberseite der Halteplatte 7 etwas abgehoben, so daß sich ein Ringspalt 16 bildet und die Unterseite 13 des über der Halteplatte 7 schwebenden, scheibenförmigen Gegenstandes 8 mit dem inerten, gasförmigen Medium bespült wird. Über die an das haubenförmige Gehäuse 1 angeschlossene Leitung 4 nun ein gasförmiges Ätzmedium beispielsweise (N₂ + HF) eingeleitet, so daß die von der Halteplatte 7 abgekehrte Seite 20 des Gegenstandes 8 geätzt wird, beispielsweise um eine auf dem Siliziumwafer vorgesehene Oxidschicht zu entfernen.

Dadurch, daß durch den düsenartigen Ringspalt 16 zwischen dem von der Halteplatte 7 geringfügig abgehobenen Gegenstand 8 und der Oberseite 21 der Halteplatte 7 das inerte, gasförmige Medium ausströmt, wird erreicht, daß das ätzende, gasförmige Medium entweder überhaupt nicht auf die Unterseite 13 des Gegenstandes 8 gelangt (insbesondere, wenn die Ausführungsform der Fig. 1 und 2 verwendet wird), oder das ätzende, gasförmige Medium wirkt nur in einem genau definierten Randbereich der der Halteplatte 7 zugekehrten Seite 13 des scheibenförmigen Gegenstandes 8 (insbesondere wenn die Ausführungsform der Fig. 3 und 4 verwendet wird), so daß dort definiert geätzt wird.

Im Bereich des düsenartigen Ringspaltes 16, der nach oben vom Rand 14 des Gegenstandes 8 und nach unten vom Rand 15 der Vertiefung 9 in der Halteplatte 7 begrenzt wird, tritt beim Ausströmen des inerten Gases durch den Ringspalt 16 der Bernoulli-Effekt auf, so daß ohne weitere Maßnahmen verhindert ist, daß der scheibenförmige Gegenstand 8 durch das inerte Gas von der Halteplatte 7 weggeblasen wird, obwohl er über die Hakteplatte schwebt.

Sowohl das ätzende, gasförmige Medium, das die Oberseite 20 des Gegenstandes 8 ätzt, als auch das inerte, gasförmige Medium, das die Unterseite 13 des Gegenstandes 8 bespült, werden durch die rings um die Vertiefung 9 in der Halteplatte 7 vorgesehenen Absaugöffnungen 12 aus der Prozeßkammer 5 abgeführt.

Sobald der Ätzvorgang beendet ist, wird die Prozeßkammer 5 mit einem inerten, gasförmigen Medium, z.B. reinem Stickstoff, gespült und dann die Halteplatte 7 vom haubenförmigen Gehäuse 1 abgenommen und beispielsweise eine weitere Halteplatte 7, auf der ein zu behandelnder Gegenstand 8 aufgelegt ist, gegenüber dem haubenförmigen Gehäuse 1 in Stellung gebracht, worauf ein weiterer Ätzvorgang durchgeführt werden kann.

Zusammenfassend kann ein bevorzugtes Ausführungsbeispiel der Erfindung wie folgt beschrieben werden:

Zum einseitigen Ätzen von Siliziumwafer 8 im Trockenätzverfahren ist eine Vorrichtung vorgesehen, die aus einem haubenförmigen Gehäuse 1 und eine an diese angelegte Halteplatte 7 für den zu ätzenden Siliziumwafer 8 besteht. Das haubenförmige Gehäuse 1 und die an ihm angelegte Halteplatte 7 umgrenzen eine Prozeßkammer 5, in die ein Ätzwirkung entfaltendes, gasförmiges Medium, z.B. ein Gemisch aus Stickstoff und Fluorwasserstoff eingeleitet werden kann. In der Halteplatte 7 ist eine Vertiefung 9 vorgesehen, um die herum Haltestifte 11 für den Siliziumwafer 8 und Absaugöffnungen 12 zum Abziehen von Gas aus der Prozeßkammer 5 angeordnet sind. Der zu behandelnde Siliziumwafer 8 wird mit seiner zu ätzenden Seite 20 nach oben auf die Halteplatte 7 aufgelegt und in die Vertiefung 9 in der Halteplatte 7 ein bezüglich der durch Ätzen zu entfernenden Schicht inertes, gasförmiges Medium eingeleitet. Dadurch wird der Siliziumwafer 8 vom Rand 15 der Vertiefung 9 in der Halteplatte 7 abgehoben, so daß sich ein Ringspalt 16 ergibt, aus dem das inerte gasförmige Medium zwischen Halteplatte 7 und Siliziumwafer 8 ausströmen kann. Das in die Prozeßkammer 5 eingeblasene Ätzmedium bespült die von der Halteplatte 7 abgekehrte Fläche 20 des Siliziumwafer 8 und kann wegen des durch den Ringspalt 16 zwischen Siliziumwafer 8 und Halteplatte 7 austretenden, inerten Gases nicht oder nicht unkontrolliert auf die der Halteplatte 7 zugekehrte Fläche 13 des Siliziumwafer 8 gelangen, so daß ein Unterätzen auch im Randbereich des Siliziumwafer 8 verhindert ist, oder nur in einem definierten Randbereich erfolgt.

## Patentansprüche

1. Verfahren zum Behandeln von scheibenförmigen Gegenständen, insbesondere Siliziumwafer, wobei die zu behandelnde Seite des scheibenförmigen Gegenstandes mit einem Behandlungs-Medium und die nicht zu behandelnde Seite des scheibenförmigen Gegenstandes mit einem inerten Medium umspült wird, indem auf die zu behandelnde Seite des scheibenförmigen Gegenstandes ein gasförmiges Behandlungs-Medium und auf die nicht zu behandelnde Seite des scheibenförmigen Gegenstandes ein inertes, gasförmiges Medium geblasen wird, wobei das inerte, gasförmige Medium in einen durch eine Vertiefung in einer Halteplatte für den scheibenförmigen Gegenstand gebildeten Raum eingeleitet, bis in den Bereich des Umfangsrandes des scheibenförmigen Gegenstandes geführt wird, und im Bereich des Umfangsrandes des scheibenförmigen Gegenstandes durch einen Ringspalt austritt, der zwischen der Halteplatte - und dem scheibenförmigen Gegenstand gebildet wird, **dadurch gekennzeichnet, daß** der der nicht zu behandelnden Seite des scheibenförmigen Gegenstandes zugewendete, mit dem inerten, gasförmigen Medium beaufschlagte Raum, durch eine Vertiefung in der Halteplatte gebildet wird, welche Vertiefung kleiner ist als der zu behandelnde, scheibenförmige Gegenstand, und daß der Ringspalt düsenartig ist und auf einer Seite von der der Halteplatte zugewendeten Seite des Umfanges des scheibenförmige Gegenstandes und auf der anderen Seite von dem durch den Umfangsrand des scheibenförmigen Gegenstandes überdeckten, die Vertiefung umgebenden Bereich der dem scheibenförmige Gegenstand zugewendeten Seite der Halteplatte begrenzt wird.

2. Verfahren nach Anspruch 1, **dadurch gekennzeichnet, daß** auf die eine Seite des scheibenförmigen Gegenstandes ein gasförmiges Ätzmedium geblasen wird, um von diesen eine Schicht durch Ätzen zu entfernen, und daß auf die nicht zu behandelnde Seite des scheibenförmigen Gegenstandes ein bezüglich der durch Ätzen zu entfernenden Schicht inertes, gasförmiges Medium geblasen wird.

3. Verfahren nach Anspruch 2, **dadurch gekennzeichnet, daß** von einer Fläche eines Siliziumwafer eine Oxidschicht, wie an sich bekannt, durch Ätzen mit in Stickstoff gelöstem Fluorwasserstoff entfernt wird und daß die andere Fläche des Siliziumwafer mit Stickstoff bespült wird.

4. Vorrichtung zum Durchführen des Verfahrens nach einem der Ansprüche 1 bis 3, mit einer Prozeßkammer (5), in die über eine Leitung (4) gasförmiges Behandlungs-Medium, insbesondere ein gasförmiges Ätzmedium, eingeleitet wird, und die von einem Gehäuse (1) bestehend aus einem haubenförmig ausgebildeten Gehäuseteil (2, 3) und einer Halteplatte (7) für den zu behandelnden, scheibenförmigen Gegenstand (8) umgrenzt ist, wobei eine Leitung (4) zum Zuführen des gasförmigen Behandlungs-Mediums im haubenförmigen Gehäuseteil (2, 3) mündet, und wobei in der Halteplatte (7) für den scheibenförmigen Gegenstand (8) im Auflagebereich des scheibenförmigen Gegenstandes (8) wenigstens eine Vertiefung (9) vorgesehen ist, in der eine Leitung (10) zum Zuführen von inertem, gasförmigem Medium, insbesondere von bezüglich der zu ätzenden Schicht inertem, gasförmigen Medium, mündet, und wobei zwischen dem scheibenförmigen Gegenstand (8) und der Halteplatte (7) ein Ringspalt (16) für den Austritt von inertem, gasförmigen Medium aus der Vertiefung (9) vorgesehen ist, **dadurch gekennzeichnet, daß** die Vertiefung (9) in der Halteplatte (7) kleiner ist als der zu behandelnde scheibenförmige Gegenstand (8) und daß der Ringspalt (16) düsenartig ist und zwischen dem der Halteplatte (7) zugewendeten ümfangsrand (14) des scheibenförmigen Gegenstandes (8) und dem die Vertiefung (9) umgebenden Bereich (15) der dem scheibenförmigen Gegenstand (8) zugewendeten Fläche (21) der Halteplatte (7) vorgesehen ist.

5. Vorrichtung nach Anspruch 4, **dadurch gekennzeichnet, daß** der haubenförmige Gehäuseteil (2, 3) mit seinem freien Rand (6) an der Halteplatte (7) für den scheibenförmigen Gegenstand (8) anlegbar ist.

6. Vorrichtung nach Anspruch 4 oder 5, **dadurch gekennzeichnet**, daß rings um die Vertiefung (9) in der Halteplatte (7) Stifte (11) zum seitlichen Stützen des scheibenförmigen Gegenstandes (8) angeordnet sind.

7. Vorrichtung nach einem der Ansprüche 4 bis 6, **dadurch gekennzeichnet, daß** in der Halteplatte (7) rings um die Vertiefung (9) in der Halteplatte (7) Öffnungen (12) zum Abziehen der gasförmigen, in die Prozeßkammer (5) eingeführten Medien vorgesehen sind.

8. Vorrichtung nach Anspruch 7, **dadurch gekennzeichnet, daß** die Öffnungen (12) außerhalb der Stifte (11) angeordnet sind.

9. Vorrichtung nach Anspruch 7, **dadurch gekennzeichnet, daß** die Öffnungen (12) innerhalb der Stifte (11) angeordnet sind.

## Claims

1. A method for processing disc-shaped articles, especially silicon wafers, wherein the side of the disc-shaped article to be processed is bathed with a processing medium and the side of the disc-shaped article not to be processed is bathed with an inert medium, in that a gaseous processing medium is blown on to the side of the disc-shaped article to be processed and an inert, gaseous medium is blown on to the side of the disc-shaped article not to be processed, wherein the inert, gaseous medium is introduced into a space formed by a recess in a supporting plate for the disc-shaped article and fed to the region of the peripheral edge of the disc-shaped article and emerges in the region of the peripheral margin of the disc-shaped article through an annular gap, which is formed between the supporting plate and the disc-shaped article, **characterized in that** the space facing the side of the disc-shaped article not to be processed and subjected to the inert, gaseous medium is formed by a recess in the supporting plate, which recess is smaller than the disc-shaped article to be processed and in that the annular gap is formed like a nozzle and is bounded on one side by the side of the periphery of the disc-shaped article facing the supporting plate and on the other side by the region of the side of the supporting plate facing the disc-shaped article which is overlapped by the peripheral margin of the disc-shaped article.

2. A method according to claim I, **characterized in that** a gaseous etching medium is blown on to the one side of the disc-shaped article, in order to remove a layer from this by etching, and in that a gaseous medium which is inert relative to the layer to be removed by etching is blown on to the side not to be processed.

3. A method according to claim 2, **characterized in that** an oxide layer is removed from one surface of a silicon wafer as is known per se by etching with hydrogen fluoride dissolved in nitrogen and in that the other surface of the silicon wafer is bathed in nitrogen.

4. Apparatus for carrying out the method according to any of claims I to 3, with a processing chamber (5), into which a gaseous processing medium, especially a gaseous etching medium, is introduced through a line (4), and which is bounded by a housing (1) consisting of a housing part (2, 3) of hood form and a supporting plate (7) for the disc-shaped article (8) to be processed, wherein a line (4) for feeding the gaseous processing medium opens into the housing part (2, 3) of hood form, and wherein at least one recess (9) is provided in the supporting plate (7) for the disc-shaped article (8) in the support region of the disc-shaped article (8) and a line (10) for feeding in an inert, gaseous medium, inert especially relative to the layer to be etched, opens into the recess, and wherein an annular gap (16) for the escape of inert, gaseous medium from the recess (9) is provided between the disc-shaped article (8) and the supporting plate (7), **characterized in that** the recess (9) in the supporting plate (7) is smaller than the disc-shaped article (8) to be processed and in that the annular gap (16) is of nozzle form and is provided between the peripheral margin (14) of the disc-shaped article (8) facing the supporting plate (7) and the region (15) surrounding the recess (9) of the surface (21) of the supporting plate (7) facing the disc-shaped article (8).

5. Apparatus according to claim 4, **characterized in that** the housing part (2, 3) of hood form can have its free edge (6) placed on the supporting plate (7) for the disc-shaped article (8).

6. Apparatus according to claim 4 or 5, **characterized in that** pins (11) are arranged around the recess (9) in the supporting plate (7) for lateral support of the disc-shaped article (8).

7. Apparatus according to any of claims 4 to 6, **characterized in that** openings (12) are provided in the supporting plate (7) around the recess (9) in the supporting plate (7), for drawing off the gaseous medium introduced to the processing chamber (5).

8. Apparatus according to claim 7, **characterized in that** the openings (12) are arranged outside the pins (11).

9. Apparatus according to claim 7, **characterized in that** the openings (12) are arranged inside the pins (11).

## Revendications

1. Procédé de traitement d'objets en forme de disque, en particulier de plaquettes de silicium, dans lequel la face à traiter de l'objet en forme de disque est exposée à un milieu de traitement et la face non traitée de l'objet en forme de disque est exposée à un milieu inerte, un milieu de traitement gazeux étant dirigé sur la face à traiter de l'objet en forme de disque et un milieu gazeux inerte étant dirigé sur la face non traitée de l'objet en forme de disque, dans lequel le milieu gazeux inerte est introduit dans une chambre formée par une cavité dans une plaque de support pour l'objet en forme de disque, est amené jusque dans la région du bord extérieur de l'objet en forme de disque et, dans la région du bord extérieur de l'objet en forme de disque, s'échappe par un espace annulaire ménagé entre la plaque de support et l'objet en forme de disque, **caractérisé en ce que** la chambre tournée vers la face non traitée de l'objet en forme de disque, alimentée en milieu gazeux inerte est formée d'une cavité dans la plaque de support, plus petite que l'objet en forme de disque à traiter, et en ce que l'espace annulaire est conformé en buse et est délimité, d'un côté par la zone périphérique de la face de l'objet en forme de disque tournée vers la plaque de support, et de l'autre par la zone entourant la cavité recouverte par le bord périphérique de l'objet en forme de disque, tournée vers l'objet en forme de disque.

2. Procédé selon la revendication 1, **caractérisé en ce que** sur une face de l'objet en forme de disque on dirige un milieu d'attaque gazeux, aux fins d'éliminer une couche de celui-ci par attaque chimique et en ce qu'on dirige sur la face non traitée de l'objet en forme de disque un milieu gazeux inerte vis-à-vis de la couche à éliminer par attaque chimique.

3. Procédé selon revendication 2, **caractérisé en ce qu**'on élimine une couche d'oxyde sur une surface d'une plaquette de silicium, d'une manière connue en soi, par attaque chimique avec du fluorure d'hydrogène dissous dans de l'azote et en ce qu'on rince l'autre surface de la plaquette de silicium avec de l'azote.

4. Dispositif pour la mise en ouvre du procédé selon une des revendications 1 à 3, comportant une chambre de traitement (5) à l'intérieur de laquelle un milieu de traitement gazeux, en particulier un milieu de traitement gazeux d'attaque est introduit par l'intermédiaire d'une conduite (4), et qui est délimitée par une enveloppe (1) avec un élément d'enveloppe (2, 3) en forme de coiffe et une plaque de support (7) pour l'objet (8) en forme de disque à traiter, une conduite (4) débouchant dans l'élément d'enveloppe (2, 3) en forme de coiffe, pour amener le milieu de traitement gazeux, et au moins une cavité (9), dans laquelle débouche une conduite (10) pour amener du milieu gazeux inerte, en particulier du milieu gazeux inerte vis-à-vis de la couche à attaquer, étant aménagée dans la plaque de support (7) pour l'objet (8) en forme de disque, dans la zone d'appui dudit objet (8) en forme de disque, et un espace annulaire (16) pour la sortie du milieu inerte gazeux hors de la cavité (9) étant prévue entre l'objet (8) en forme de disque et là plaque de support (7), **caractérisé en ce que** la cavité (9) dans la plaque de support (7) est plus petite que l'objet (8) en forme de disque à traiter et en ce que l'espace annulaire (16) est conformé en buse et est aménagé entre le bord périphérique (14) de l'objet (8) en forme de disque tourné vers la plaque de support (7) et la zone (15) entourant la cavité (9) dans la surface (21) de la plaque de support (7) tournée vers l'objet (8) en forme de disque.

5. Dispositif selon la revendication 4, **caractérisé en ce que** l'élément d'enveloppe (2, 3) en forme de coiffe peut être appliqué avec son bord (6) libre sur la plaque de support (7) pour l'objet (8) en forme de disque.

6. Dispositif selon la revendication 4 ou 5, **caractérisé en ce que** des goupilles (11) sont prévues sur la plaque de support (7), tout autour de la cavité (9), en tant qu'appui latéral pour l'objet (8) en forme de disque.

7. Dispositif selon une des revendications 4 à 6, **caractérisé en ce que** des ouvertures (12) sont prévues dans la plaque de support (7), tout autour de la cavité (9), pour l'évacuation des milieux gazeux introduits dans la chambre de traitement (5).

8. Dispositif selon la revendication 7, **caractérisé en ce que** les ouvertures (12) sont disposées à l'extérieur des goupilles (11).

9. Dispositif selon la revendication 7, **caractérisé en ce que** les ouvertures (12) sont disposées à l'intérieur des goupilles (11).
